# EUROPÄISCHE PATENTSCHRIFT

(11) **EP 1 943 568 B1**
(45) Veröffentlichungstag und Bekanntmachung des Hinweises auf die Patenterteilung: **03.11.2010**
(21) Anmeldenummer: 06793155.0
(22) Anmeldetag: 01.09.2006
(51) Int. Cl.: G05B 19/042

(54) **VERFAHREN ZUR ENERGIEVERSORGUNG EINES FELDGERÄTES DER AUTOMATISIERUNGSTECHNIK**
METHOD FOR SUPPLYING ENERGY TO A FIELD DEVICE IN AUTOMATION TECHNOLOGY
PROCEDE D'ALIMENTATION EN ENERGIE D'UN APPAREIL DE TERRAIN DANS LE DOMAINE DE L'AUTOMATISATION

(30) Priorität: 13.09.2005 DE 102005043771
(43) Veröffentlichungstag der Anmeldung: 16.07.2008
(73) Patentinhaber: Endress+Hauser Flowtec AG, 4153 Reinach (CH)
(72) Erfinder: BUDMIGER, Thomas, CH-4107 Ettingen (CH); ROTH, Jörg, 79540 Lörrach (DE); TOUZIN, Mike, 79585 Steinen (DE); WALDHAUSER, Dieter, 87471 Durach (DE); ISELT, Torsten, 87435 Kempten (DE)
(74) Vertreter: Andres, Angelika Maria
(86) Internationale Anmeldenummer: PCT/EP2006/065936
(87) Internationale Veröffentlichungsnummer: WO 2007/031417

(56) Entgegenhaltungen:
- DE-A1- 10 309 886
- GB-A- 2 231 407
- GB-A- 2 312 801

## Beschreibung

In der Automatisierungstechnik werden vielfach Feldgeräte eingesetzt, die zur Erfassung und/oder Beeinflussung von Prozessvariablen dienen. Beispiele für derartige Feldgeräte sind Füllstandsmessgeräte, Massedurchflussmessgeräte, Druck- und Temperaturmessgeräte, pH- und Leitfähigkeitsmessgeräte etc., die als Sensoren die entsprechenden Prozessvariablen Füllstand, Durchfluss, Druck, Temperatur bzw. pH-Wert bzw. Leitfähigkeitswert erfassen.

Zur Beeinflussung von Prozessvariablen dienen Aktoren, die z. B. als Ventile den Durchfluss einer Flüssigkeit in einem Rohrleitungsabschnitt oder als Pumpen den Füllstand in einem Behälter steuern.

Als Feldgeräte werden auch Registriergeräte bezeichnet, die vor Ort Messdaten aufzeichnen.

Eine Vielzahl solcher Feldgeräte wird von der Fa. Endress+Hauser hergestellt und vertrieben.

In der Regel sind Feldgeräte in modernen Automatisierungsanlagen über Feldbussysteme (HART, Profibus, Foundation Fieldbus, etc.) mit übergeordneten Einheiten (z. B. Leitsysteme oder Steuereinheiten) verbunden, um mit diesen Daten insbesondere Messdaten auszutauschen. Diese übergeordneten Einheiten dienen unter anderem zur Prozesssteuerung, Prozessvisualisierung, Prozessüberwachung.

Die Energieversorgung der Feldgeräte erfolgt entweder direkt über die Kommunikationsleitung (2-Leiter-Geräte, loop powered) oder durch eine zusätzliche Versorgungsleitung (4-Leiter-Geräte). Der Verkabelungsaufwand insbesondere bei den 4-Leiter-Geräten ist sehr aufwendig und teuer. In beiden Fällen wird die Energie, die zum Betrieb eines Feldgeräts benötigt wird, über Kabel übertragen.

Häufig sind die übergeordneten Einheiten in Unternehmensnetzwerke integriert. Damit kann aus unterschiedlichen Bereichen eines Unternehmens auf Prozess- bzw. Feldgerätedaten zugegriffen werden.

Zur weltweiten Kommunikation können die Firmennetzwerke auch mit öffentlichen Netzwerken, z. B. dem Internet verbunden sein.

Seit kurzer Zeit sind auch Anwendungen bekannt, bei denen Feldgeräte nicht mehr an kabelgebundene Feldbussysteme angeschlossen sind, sondern bei denen die Feldgeräte Daten via Funk übertragen. Hierzu benötigen die Feldgeräte eine entsprechende Funkschnittstelle. Diese Funkverbindung kann auch als Funknetzwerk ausgebildet sein.

Der wesentliche Vorteil dieser Funk-Feldgeräte besteht darin, dass sie keinerlei Verkabelung benötigen. Dadurch können sie schnell und einfach an beliebigen Orten installiert und eingesetzt werden.

Funk-Feldgeräte werden entweder über Batterie oder über kleine lokale Energieversorgungseinheiten versorgt. Die Energieversorgungseinheit kann z. B. ein Solarmodul oder eine Brennstoffzelle sein. Der Solarbetrieb hat zwar den Vorteil dass er relativ wartungsfrei arbeitet, aber Sonnenenergie steht bei vielen Anwendungen nicht oder nur zeitweise beschränkt zur Verfügung.

Dokument GB-A-2 231 407 offenbart eine Überwachungsvorrichtung für einen Abscheider, der zum Abscheiden eines Kondensats dient Ein entsprechender Detektor, der das Vorhandensein von Kondensat feststellt, wird mittels eines thermoelektrischen Generators mit Energie versorgt Der thermoelektrische Generator kann bspw. aus einem Peltier-Element bestehen. Diese Überwachungsvorrichtung wird von dem thermoelektrischen Generator mit Energie versorgt. Dabei macht sich der thermoelektrische Generator einen Temperaturunterschied zwischen dem Prozessmedium und der Umgebung zu nutze.

Alle übrigen Lösungen benötigen einen regelmäßigen Austausch des Energieträgers, was für den Anwender sehr aufwendig sein kann.

Aufgabe der Erfindung ist es deshalb, ein Verfahren zur Energieversorgung eines Feldgerätes der Automatisierungstechnik anzugeben, das die oben genannten Nachteile nicht aufweist, dass insbesondere eine wartungsfreie Energieversorgung gewährleistet.

Gelöst wird diese Aufgabe durch folgende im Anspruch 1 angegebenen Merkmale.

Die wesentliche Idee der Erfindung besteht darin, die zum Betrieb des Feldgerätes benötigte Energie über das Prozessmedium unabhängig von der Umgebungstemperatur des Feldgerätes zu gewinnen. In der Regel werden Informationen aus dem Prozess nur benötigt, wenn das betreffende Prozessmedium mit seinen laufenden Prozessparametern vorliegt. Als Beispiel sei hier eine Heißdampfanwendung genannt, bei der Dampfmenge, die pro Zeiteinheit durch ein Rohr strömt, zu bestimmen ist. Nur wenn der Dampf in der Rohrleitung vorhanden ist und fließt, wird der entsprechende Messwert benötigt.

Erfindungsgemäß werden Temperaturdifferenzen im Prozessmedium, wie sie z. B. zwischen einem Vorlauf und einem Rücklauf auftreten können, zur Energiegewinnung für das Feldgerät genutzt.

In vorteilhafter Weise handelt es sich bei dem Thermogenerator um ein Peltier-Element. Solche Elemente sind sehr effizient und relativ kostengünstig.

Seit kurzem stehen Micro-Peltier-Elemente zur Verfügung, die in Arrays angeordnet, eine sehr hohe Leistungsausbeute ergeben.

Als Energiepuffer dient eine Energiespeichereinheit in der überschüssige Energie zwischengespeichert werden kann, um zu Zeiten, wo relativ wenig Energie aus dem Prozessmedium gewonnen werden kann, den Betrieb des Feldgerätes aufrecht zu erhalten.

In einer Weiterentwicklung der Erfindung ist eine Energie-Steuer-Einheit vorgesehen, die die Energieverteilung und den Energieverbrauch im Feldgerät regelt. Steht z. B. wenig Energie zur Verfügung und ist die Energiespeichereinheit relativ leer, so muss der Energieverbrauch im Feldgerät entsprechend gedrosselt werden.

Nachfolgend ist die Erfindung anhand eines in der Zeichnung dargestellten Ausführungsbeispiels näher erläutert.

Es zeigen:

Fig. 1 Netzwerk der Automatisierungstechnik in schematischer Darstellung;

Fig.2 Blockschaltbild eines herkömmliche Feldgerätes mit kabelgebundener Datenübertragung und Versorgung über den Feldbus;

Fig. 3 Blockschaltbild eines Funk-Feldgerätes mit der erfindungsgemäßen Energieversorgung;

Fig. 4 Anwendungsbeispiel der Erfindung;

Fig. 4a alternatives Anwendungsbeispiel der Erfindung.

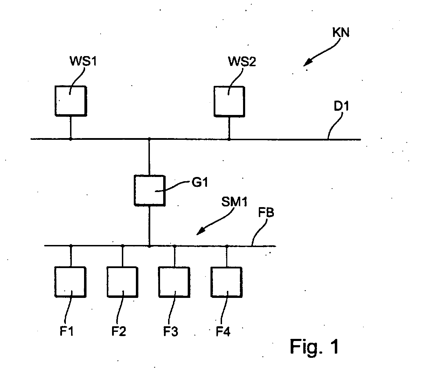

In Fig. 1 ist ein Netzwerk der Automatisierungstechnik näher dargestellt. An einem Datenbus D1 sind mehrere Rechnereinheiten z. B. Workstations WS1, WS2, angeschlossen. Diese Rechnereinheiten dienen als übergeordnete Einheiten (Leitsysteme bzw. Steuereinheiten), unter anderem zur Prozessvisualisierung, Prozessüberwachung und zum Engineering sowie zum Bedienen und Überwachen von Feldgeräten. Der Datenbus D1 arbeitet z. B. nach dem Profibus DP-Standard oder nach dem HSE (High Speed Ethernet)-Standard der Foundation Fieldbus.

Über ein Gateway G1, das auch als Linking Device oder auch als Segment-Koppler bezeichnet wird, ist der Datenbus D1 mit einem Feldbus-Segment SM1 verbunden. Das Feldbus-Segment SM1 1 besteht aus mehreren Feldgeräten F1, F2, F3, F4, die über einen Feldbus FB miteinander verbunden sind. Bei den Feldgeräten F1, F2, F3, F4 kann es sich um Sensoren oder um Aktoren handeln. Der Feldbus FB arbeitet entsprechend nach einem der bekannten Feldbusstandards Profibus, Foundation Fieldbus oder HART.

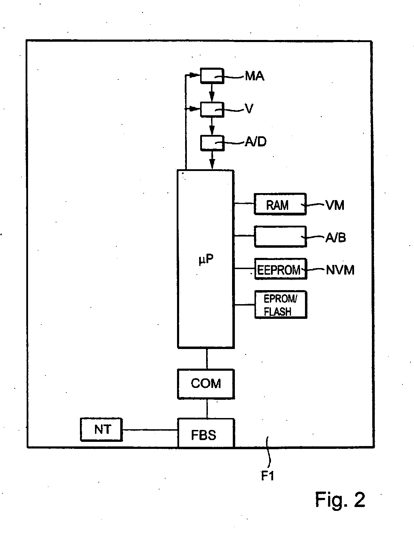

In Fig. 2 ist ein Blockschaltbild eines herkömmlichen Feldgerätes z. B. F1 näher dargestellt. Ein Mikroprozessor µP ist zur Messwertveraubeitung über einen Analog-Digital-Wandler A/D und einen Verstärker V mit einem Messaufnehmer MA verbunden, der eine Prozessvariable (z. B. Druck, Durchfluss oder Füllstand) erfasst. Der Mikroprozessor µP ist mit mehreren Speichern verbunden. Der Speicher VM dient als temporärer (flüchtiger) Arbeitspeicher RAM. Ein weitere Speicher EPROM oder Flash-Speicher FLASH dient als Speicher für das im Mikroprozessor µP auszuführende Steuerprogramm. In einem nichtflüchtigen beschreibbaren Datenspeicher NVM z. B. EEPROM-Speicher werden Parameterwerte (z. B. Kalibrierdaten etc.) abgespeichert.

Das im Mikroprozessor µP ablaufende Steuerprogramm definiert die anwendungsbezogenen Funktionalitäten des Feldgerätes (Messwertberechnung, Hüllkurvenauswertung, Linearisierung der Messwerte, Diagnoseaufgaben).

Weiterhin ist der Mikroprozessor µP mit einer Anzeigebedieneinheit A/B (z. B. LCD-Anzeige mit mehreren Drucktasten) verbunden.

Zur Kommunikation mit dem Feldbus-Segment SM1 ist der Mikroprozessor µP über einen Kommunikations-Controller COM mit einer Feldbusschnittstelle FBS verbunden. Ein Netzteil NT liefert die notwendige Energie für die einzelnen Elektronikkomponenten des Feldgerätes F1. Im vorliegenden Fall liefert der Feldbus FB die zum Betrieb des Feldgerätes benötigte Energie.

Die Leitungen für die Energieversorgung der einzelnen Komponenten im Feldgerät sind der Übersichtlichkeit halber nicht eingezeichnet.

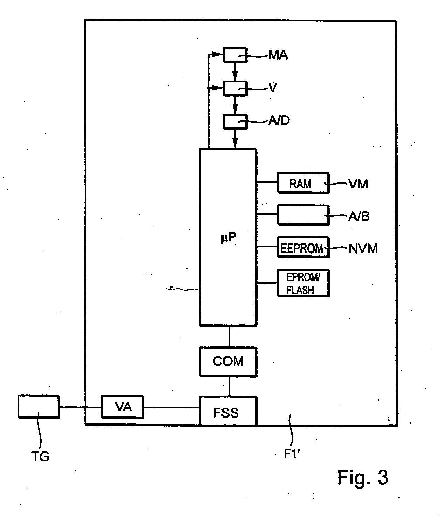

Fig. 3 zeigt ein Blockschaltbild eines Funk-Feldgerätes F1' mit einer erfindungsgemäßen Energieversorgung. Der Aufbau des Feldgerätes F1' entspricht im Wesentlichen dem Aufbau des in Fig. 2 dargestellten Feldgerätes F1. Im Unterschied zu dem in Fig. 2 gezeigten Feldgerät F1 weist das Feldgerät F1' jedoch keine Feldbusschnittstelle sondern eine Funkschnittstelle FSS auf. Über diese Funkschnittstelle können Daten vom Feldgerät F1' z. B. an übergeordnete Einheiten gesendet bzw. von diesem empfangen werden.

Weiterhin weist das Feldgerät F1' kein Netzteil NT sondern einen Versorgungsanschluss VA, der mit einem Thermogenerator TG über eine Leitung L verbunden ist, auf. Der Thermogenerator TG liefert die zum Betrieb des Feldgerätes benötigte Energie. Die Leitungen vom Versorgungsausschluss VA zu den einzelnen Komponenten des Feldgerätes sind der Übersichtlichkeit halber ebenfalls nicht eingezeichnet.

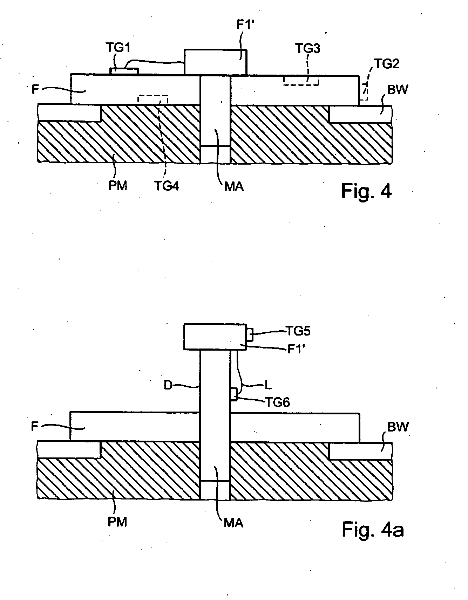

Fig. 4 zeigt ein mögliches Anwendungsbeispiel für ein Feldgerät F1' mit einer erfindungsgemäßen Energieversorgung. Das Feldgerät F1' sitzt auf einem Flansch F der als Prozessanschluss dient. Der Messaufnehmer MA reicht durch den Flansch F in das Prozessmedium PM. Typischerweise handelt es sich bei dem Messaufnehmer MA um einen Temperatursensor, z.. B. einen PT100. Der Flansch F ist an einer Behälterwand BW befestigt. In Fig. 4 sind mehrere alternative Anordnungen für Thermogeneratoren dargestellt. Der Thermogenerator TG1 ist direkt auf dem Flansch F angebracht. Alle weiteren alternativen Anordnungen sind gestrichelt dargestellt. So ist der Thermogenerator TG2 seitlich am Flansch F angebracht ist. Denkbar ist es auch Thermogeneratoren direkt in den Flansch F zu integrierern. Dies zeigt der Thermogenerator TG3. Eine weitere Alternative bietet der Thermogenerator TG4, der mediumseitig am Flansch F angebracht ist.

Fig. 4a zeigt eine weitere alternative Ausgestaltung der Erfindung, bei der der Thermogenerator TG6 an einem Distanzstück D, das zwischen dem Flansch F und dem Gehäuse des Feldgeräts F1' vorgesehen ist, angebracht ist. In einer weiteren alternativen Anordnung kann der Thermogenerator TG5 auch direkt am Gehäuse des Feldgerätes F1' vorgesehen sein.

Nachfolgend ist die Funktionsweise der Erfindung nochmals näher erläutert. Der Thermogenerator TG liefert die für den Betrieb des Feldgerätes F1' benötigte Energie. Dabei wird die Temperaturdifferenz zwischen dem Prozessmedium PM und der Umgebung besteht ausgenutzt. Eine ausreichende Temperaturdifferenz liefern z. B. Heißdampf-Anwendungen, bei denen Dampf mit einer Temperatur von z. B. 150° C durch einen Rohrleitungsabschnitt strömt.

Die Energieausbeute eines Thermogenerators steigt mit der Größe der Temperaturdifferenz, die zwischen der Ober- und der Unterseite des Thermogenerators herrscht. Deshalb ist die geeignete Anordnung des Thermogenerators besonders wichtig, um die vorhandenen Temperaturunterschiede optimal auszunutzen. Wie die Figuren 4 und 4a zeigen, können die Thermogeneratoren an unterschiedlichen Stellen am Prozessanschluss bzw. am Gehäuse des Feldgerätes vorgesehen sein.

In einer vorteilhaften Ausgestaltung der Erfindung handelt es sich bei den Thermogeneratoren um Peltier-Elemente bzw. um Arrays von Micro-Peltier-Elementen. Derartige Arrays liefern auch bei einer relativ kleinen Fläche von einigen Quadratzentimetern und einer leicht erzielbaren Temperaturdifferenz von 10° K eine ausreichende Leistung von bis zu 50 - 100 mW, die zum Betrieb eines Feldgerätes ausreicht.

Selbstverständlich ist es auch möglich, die vom Thermogenerator gelieferte Energie teilweise in eine Energiespeichereinheit (z. B. ein Gold-Cup) einzuspeisen. Diese überschüssige Energie kann dann zu späteren Zeitpunkten abgerufen werden.

Um den Energieverbrauch des Feldgerätes optimal anzupassen, ist eine Energie-Steuereinheit vorgesehen, die den Energieverbrauch des Feldgerätes und die Energieverteilung im Feldgerät regelt. Im Wesentlichen wird diese Energie- Steuereinheit vom Mikroprozessor µP realisiert, der das Steuerverfahren ausführt.

Die erfindungsgemäße Energieversorgung eignet sich besonders bei Feldgeräten, die via Funk kommunizieren. Sie ist extrem wartungsarm und sehr kostengünstig.

Es ist auch denkbar, dass nur ein Teil der zur Energieversorgung eines Feldgerätes notwendigen Energie mit Hilfe von Thermogeneratoren gewonnen wird. So können 4-Leiter-Geräte zu 2-Leiter-Geräten umgerüstet werden. Das Leitungspaar für die Energieversorgung kann in diesem Fall entfallen. Dieses umgerüstete Feldgerät entspräche dann dem in Fig. 2 dargestellten ergänzt um die Komponenten Thermogenerator plus Versorgungsanschluss.

## Patentansprüche

1. Verfahren zur Energieversorgung eines Feldgerätes der Automatisierungstechnik, das zur Erfassung oder Beeinflussung einer chemischen und/oder physikalischen Eigenschaft eines Prozessmediums dient und von einem Mikroprozessor gesteuert wird,
wobei die zum Betreiben des Feldgerätes benötigte Energie mittels des Prozessmediums und mit Hilfe eines Thermogenerators gewonnen wird, **dadurch gekennzeichnet, dass** der Thermogenerator zur Energiegewinnung eine Temperaturdifferenz im Prozessmedium nutzt.

2. Verfahren nach Anspruch 1, **dadurch gekennzeichnet, dass** als Thermogenerator ein Peltier-Element verwendet wird.

3. Verfahren nach Anspruch 1, **dadurch gekennzeichnet, dass** das Peltier-Element aus einem Array von Micro-Peltier-Elementen besteht.

4. Verfahren nach Anspruch 2, **dadurch gekennzeichnet, dass** eine Energiespeichereinheit verwendet wird, die zum Zwischenspeichern der vom Peltier-Element gelieferten Energie dient.

5. Verfahren nach einem der vorhergehenden Ansprüche, **dadurch gekennzeichnet, dass** eine im Feldgerät vorgesehene Energie-Steuer-Einheit verwendet wird, die die Energieverteilung und den Energieverbrauch im Feldgerät regelt.

6. Verfahren nach einem der vorhergehenden Ansprüche, **dadurch gekennzeichnet, dass** Heißdampf als Prozessmedium verwendet wird.

7. Vorrichtung zur Energieversorgung eines Feldgerätes der Automatisierungstechnik, das zur Erfassung oder Beeinflussung einer chemischen und/oder physikalischen Eigenschaft eines Prozessmediums dient und von einem Mikroprozessor gesteuert wird, wobei ein Thermogenerator vorgesehen ist, **dadurch gekennzeichnet, dass** der Thermogenerator dazu dient, die zum Betrieben des Feldgerätes benötigte Energie mittels des Prozessmediums unter Ausnutzung einer Temperaturdifferenz im Prozessmedium zu gewinnen.

## Claims

1. Method for supplying power to a field device used in automation engineering, said device being used to record or influence a chemical and/or physical property of a process medium and being controlled by a microprocessor, where the energy required to operate the field device is generated using the process medium and a thermoelectric generator, **characterized in that** the thermoelectric generator uses a difference in temperature in the process medium to generate energy.

2. Method as per Claim 1, **characterized in that** a Peltier element is used as the thermoelectric generator.

3. Method as per Claim 1, **characterized in that** the Peltier element consists of an array of micro-Peltier elements.

4. Method as per Claim 2, **characterized in that** an energy storage unit is used for the intermediate storage of the energy provided by the Peltier element.

5. Method as per one of the previous claims, **characterized in that** an energy control unit provided in the field device is used and regulates the distribution of energy and energy consumption in the field device.

6. Method as per one of the previous claims, **characterized in that** hot steam is used as the process medium.

7. Unit for supplying power to a field device used in automation engineering, said device being used to record or influence a chemical and/or physical property of a process medium and being controlled by a microprocessor, where a thermoelectric generator is provided, **characterized in that** the thermoelectric generator is used to generate the energy required to operate the field device using the process medium by exploiting a difference in temperature in the process medium.

## Revendications

1. Procédé destiné à l'alimentation en énergie d'un appareil de terrain de la technique d'automatisation, lequel procédé sert à la mesure ou à l'influence d'une caractéristique chimique et/ou physique d'un produit à mesurer, et est commandé par un microprocesseur,
l'énergie nécessaire au fonctionnement de l'appareil de terrain étant produite par l'intermédiaire du produit à mesurer et à l'aide d'un thermogénérateur, **caractérisé en ce que** le thermogénérateur utilise pour la production de l'énergie une différence de température au sein du produit à mesurer.

2. Procédé selon la revendication 1, **caractérisé en ce qu'**est utilisé un élément Peltier en tant que thermogénérateur.

3. Procédé selon la revendication 1, **caractérisé en ce que** l'élément Peltier est constitué d'un réseau de micro-éléments Peltier.

4. Procédé selon la revendication 2, **caractérisé en ce qu'**est utilisée une unité de stockage d'énergie, laquelle sert au stockage intermédiaire de l'énergie fournie par l'élément Peltier.

5. Procédé selon l'unes des revendications précédentes, **caractérisé en ce qu'**est utilisée une unité de gestion d'énergie prévue dans l'appareil de terrain, laquelle unité régule la répartition et la consommation d'énergie au sein de l'appareil de terrain.

6. Procédé selon l'unes des revendications précédentes, **caractérisé en ce qu'**est utilisée de la vapeur surchauffée en tant que produit à mesurer.

7. Dispositif destiné à l'alimentation en énergie d'un appareil de terrain de la technique d'automatisation, lequel dispositif sert à la mesure ou à l'influence d'une caractéristique chimique et/ou physique d'un produit à mesurer, et est commandé par un microprocesseur, un thermogénérateur étant prévu, **caractérisé en ce que** le thermogénérateur sert à produire l'énergie nécessaire au fonctionnement de l'appareil de terrain par l'intermédiaire du produit, en utilisant une différence de température au sein du produit à mesurer.
